# EUROPEAN PATENT APPLICATION

(11) **EP 4 621 785 A1**
(43) Date of publication of application: **24.09.2025**
(21) Application number: 25158082.5
(22) Date of filing: 14.02.2025
(51) Int. Cl.: G11C 13/00

(54) **METHOD OF OPERATING PHASE CHANGE MEMORIES, CORRESPONDING DEVICE AND COMPUTER PROGRAM PRODUCT**

(30) Priority: 04.03.2024 IT 202400004711
(71) Applicant: STMicroelectronics International N.V., 1228 Plan-les-Ouates, Geneva (CH)
(72) Inventor: TOMAIUOLO, Francesco, I-95024 Acireale (Catania) (IT); BUONO, Luigi, I-95030 Gravina di Catania (Catania) (IT); RUTA, Marco, I-95027 San Gregorio di Catania (Catania) (IT); DE COSTANTINI, Diego, I-96011 Augusta (Siracusa) (IT); GIBILARO, Marco Eugenio, I-95021 Aci Castello (Catania) (IT); CONTE, Antonino, I-95030 Tremestieri Etneo (Catania) (IT)
(74) Representative: Buzzi, Notaro & Antonielli d'Oulx S.p.A.

(57) **Abstract**

A method of operating a Phase Change Memory, PCM device, the PCM device comprising a plurality of cells arranged in a plurality of tiles, said plurality of cells comprising a set of cells configured to be written via respective write operations,
the method comprising:
determining (206) a first value, said first value indicating an upper number of cells included in a same tile of the plurality of tiles that are configured to be written in respective write operations at a common write time;
determining (206) a second value, said second value indicating an upper number of cells included in the plurality of cells that are configured to be written in respective write operations at said common write time;
selecting (212), based on the first value, on the second value and on whether said write operations are set write operations or reset write operations, a plurality of subsets of said set of cells, each subset in the plurality of subsets comprising at least one cell candidate for being written in at least one of the respective write operations by applying a respective current pulse (CURR_GEN_CTL) to said at least one cell;

wherein the method comprises, for each subset in the plurality of subsets:
generating (208) a respective current pulse (CURR_GEN_CTL); and
applying (214) at said common write time said respective current pulse (IDAC_CTL; CURRENT_GEN_CTL) to the at least one candidate cell in the subset.

## Description

### Technical field

The description relates to the field of data storage technologies.

One or more embodiments can be applied to computer storage technologies such as PCM, that is, Phase Change Memory, for instance, ePCM (that is, embedded Phase Change Memory) and/or ePCM NVM (that is, Non-Volatile Memory ePCM).

### Background

Phase Change Memories, referred to as PCM, are a type of computer storage technology, that is, memory technology and, generally, a type of non-volatile random-access memory technology that can be embedded in integrated circuit (IC) semiconductor devices.

Usually, PCM operates on a bit-by-bit basis since the heat produced by an electric current flowing through a heating material called phase-change material such as, for instance, a chalcogenide glass, is used to melt and quench the phase-change material, making it amorphous, or to hold such phase-change material in its crystallization temperature range, thereby switching it to a crystalline state.

Therefore, a PCM storage unit may use such phase-change material to store 1-bit of information since the two states of the phase-change material, that is, amorphous or crystalline, are characterized by different resistance values that facilitate distinguishing one of the states from the other, that is, each of the two states corresponds to a different value of a single bit.

Thus, the phase-change material can stably exist in two states:
an amorphous or disordered state, characterized by high electrical resistivity, that is, by high resistance, for instance, about 0.6 MΩ, representing, for instance, a low logical state, for instance, '0', characterized by a low current flowing through it, or
a crystalline or ordered state, characterized by low electrical resistivity, that is, by low resistance, for example, a resistance lower than that of the amorphous state, for instance, about 18 kΩ, representing, for instance, a high logical state, for instance, '1', characterized by a high current flowing through it.

A PCM storage unit can switch between such two states by differently heating the phase-change material, that is, by applying a current to such phase-change material for a given time for switching to a first state and by applying a current of different value to such phase-change material for a different time for switching to a second state.

For instance, a "set" write operation of a specific cell, that is, setting the cell to a high logic level, may be performed by applying on the phase-change material of such specific cell a current that heats the respective phase-change material above a crystallization temperature associated to such respective phase-change material, but under a melt temperature associated with the same phase-change material, for a given time.

For instance, a "reset" write operation of a specific cell, that is, setting the cell to a low logic level, can be performed by applying on the phase-change material of such specific cell a current that heats the respective phase-change material above the melt temperature associated with such respective phase-change material for a given time, for instance, shorter than the one considered in a "set" write operation.

For instance, a read operation of a specific cell may be done by testing the resistance value, for instance, through a current pulse, of the phase-change material of the specific cell in order to detect the current phase, that is, amorphous or crystalline, of the phase-change material.

It is noted that "set" write operations and "reset" write operations may be collectively referred to as write operations in the following description, therefore, a write operation performed on a given cell may be either a set write operation, that is, to set such given cell to a high logic level, or a reset write operation, that is, to set such given cell to a low logic level.

It is also noted that the set write operations and the reset write operations can be considered as operations used for programming the PCM, that is, program operations, since such operations allow to change the state of the bits comprised in the PCM.

A single-ended PCM is a type of PCM wherein a single cell corresponds to a single bit (that is, 1 cell/bit). Read operations in single-ended PCM are performed by using a reference current supplied, for instance, by a reference current generator, and a sense amplifier receiving:
at one terminal, a current from a PCM cell that is to be read, and
at the other terminal, a reference current supplied by the reference-current generator.

Document US 2009/0161417 A1 discloses two-cells-per-bit PCM architecture (that is, 2 cell/bit), that is, PCM architecture wherein two cells contain a single bit of data and one of the two cells, a complementary cell, is programmed to the complementary state of the other of the two cells. Thus, a bit is determined by reading a bit stored in one of the two cells and comparing it to the one stored in the complementary cell, thus, performing a differential reading operation.

A differential reading operation considers both the stored value of such data in a cell in its direct form, that is, high or low logic level respectively, and the stored value of such data in a complementary cell in its complemented form, that is, low or high logic level respectively, hence, the result of the differential reading operation is obtained through the use of a sense amplifier that is configured to receive at one terminal, for instance, on a first side, for instance, a left side, or on a second side, for instance, a right side, a current of the "direct" cell that has to be read, that is, containing the data in the direct form, and at the other terminal, for instance, on the second side or on the first side respectively, a current of the associated complementary cell, that is, containing the data in the complemented form.

Thus, the "direct" cell and the complementary cell are configured to be in opposite states. For instance, if one of the two cells, for instance, the direct cell, is in a SET state (characterized by low resistance and high current), the complementary cell is in a RESET state (characterized by high resistance and low current), or vice versa.

Therefore, the sense amplifier is configured to compare the current received from the direct cell and the current received from the associated complementary cell, and:
if the current received from the direct cell is higher than the current received from the associated complementary cell, the sense amplifier is configured to read a logic level equal to 1 ("one"), that is, a high logic level, and
if the current received from the direct cell is lower than the current received from the associated complementary cell, the sense amplifier is configured to read a logic level equal to 0 ("zero"), that is, a low logic level.

As a result, a reading operation of a bit in a two-cells-per-bit PCM may be more reliable than reading operations of bits in single-ended PCMs, as a read window in two-cells-per-bit PCMs is twice as wide as that used in single-ended PCMs.

The read window in two-cells-per-bit PCMs depends on a difference between a current flowing in a direct cell and a current flowing in an associated complementary cell, which corresponds to a difference between a current flowing within a cell set to a high logic level, that is, a current flowing in a direct or in a complementary cell, and a current flowing in a cell set to a low logic level, that is, a current flowing in a complementary or in a direct cell respectively.

Conversely, the read window in single-ended PCMs depends on a difference between a current flowing in a cell, that is, a current flowing within a cell set to a high or a low logic level, and a reference current, such reference current being midway between a current flowing within a cell set to a high logic level and a cell set to a low logic level.

Hence, two-cells-per-bit PCM architectures improve the reliability of read operations as a reference current is not needed since read operations are based on differential readings and as the two-cells-per-bit read window is doubled.

In addition, two-cells-per-bit PCM architectures may usually provide higher robustness, reliability, and retention at hot than single-ended PCM architectures as two-cells-per-bit PCMs are characterized by:
redundancy of information, that is, a single bit is stored in two cells instead of a single one, and
the possibility of implementing a differential reading strategy, that is, allowing the reading of the content of cells without using a reference current.

Such differential reading strategy further allows avoiding problems related to a relaxation phenomenon affecting amorphous materials of PCM cells, which leads to an unfeasibility in selecting a reference current that is constant during the entire working life of a single-ended PCM cell.

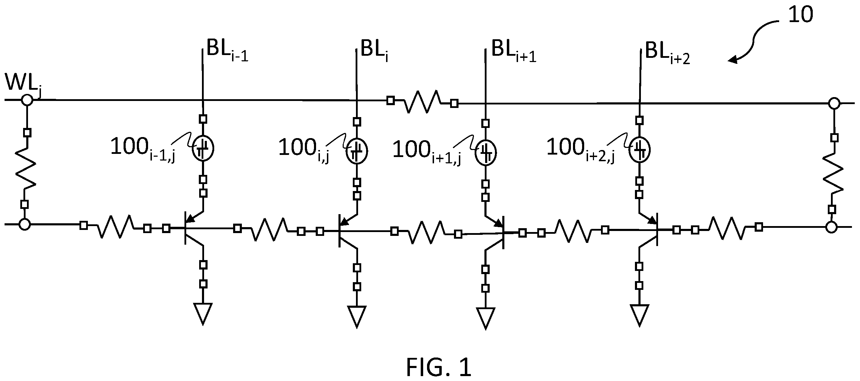

Figure 1 illustrates a conventional structure of a PCM array 10.

A PCM array 10, for instance, a two-cells-per-bit PCM array, may comprise one or more sets of cells, for instance, comprising cells 100_{i-1,j}, 100_{i,j}, 100_{i+1,j}, and 100_{i+2,j} of Figure 1, that are collectively referred to with the reference 100, coupled together.

It is noted that the resistances of Figure 1 are not physical elements but arise from parasitic connections.

It is noted that such one or more sets of cells 100 may be comprised in different subsets of the array, for instance, either in a first subset of the PCM array 10, for instance, a subset of the PCM array comprising cells that are coupled to a first side of a sense amplifier, for instance, a left side, or in a second subset of such PCM array 10, for instance, a subset of the PCM array comprising cells that are coupled to a second side of such sense amplifier, for instance, a right side.

It is noted that, if a direct cell is comprised in the first subset of the PCM array 10, the respective complementary cell is comprised in the second subset of the PCM array 10, and vice versa.

The one or more sets of cells comprised in the PCM array are arranged in word lines WL, that are, the rows of the array, and bit lines BL, that are, the columns of the array.

Each cell in the plurality of cells 100 is coupled to a respective bit line BL and to a respective word line WL, for instance, through a bipolar transistor acting as selector.

Each cell in the plurality of cells 100 is coupled to a different pair of lines comprising a bit line BL and a word line WL, so that the respective bit line BL and the respective word line WL to which a given cell is coupled can be considered as providing coordinates to unambiguously identify such given cell.

For instance, the set of cells 100 illustrated in Figure 1 is comprised in a word line WL; and each of such cells 100 is further coupled with a respective bit line, for instance, to a bit line BLᵢ₋₁, BLᵢ, BLᵢ₊₁, or BLᵢ₊₂ of Figure 1, that are collectively referred to with the reference BL.

It is noted that the cells 100 of the PCM array 10 may also be organized in tiles, such tiles being memory sub-blocks (that is, array sub-blocks) comprising cells that are arranged in bit lines BL and word lines WL, each of such tiles being accessible and operable independently.

It is noted that each time a state of a bit is changed, for instance, in response to the performing of a program operation, respective states of two cells comprising such bit (either in the direct or in the complemented form) are changed accordingly, that is, the state of the direct cell containing the bit in the direct form and the state of the complementary cell comprising the bit in the complemented form are both changed.

For instance, a cell (the direct cell or the complementary cell) that is in a RESET state before the performing of the program operation changes its state to a SET state, while the other cell (the complementary cell or the direct cell, respectively) that is in a SET state before the performing of the program operation changes its state to a RESET state.

It is noted that, during the performing of such program operation, a first current is injected in the direct cell that is to be programmed, that is, the direct cell containing the bit in the direct form that change its state, and a second current is injected in the complementary cell that is to be programmed, that is, the complementary cell containing the bit in a complemented form that change its state, such current being injected in such cells through respective bit lines BL coupled thereto.

In known solutions, PCMs are configured to perform program operations on one or more direct cells or in one or more complementary cells in parallel.

Such known solutions do not allow to perform program operations on direct cells of some bits in parallel to program operations on complementary cells of other bits.

It would be advantageous to pulse, at the same time, direct cells of some bits and complementary cells of other bits, thus, performing program operations on direct cells and complementary cells simultaneously, in order to speed up the program time of the PCM.

It would be also advantageous, in order to speed up the program time of the PCM, to manage the way the sequence of pulses used to perform program operations are provided to the direct and complementary cells, for instance, aiming at maximizing the total and/or by tile parallelism respecting the maximum parallelism constraints.

Therefore, solutions that can reduce the time required for programming the PCM, for instance, by managing sequences of pulses in order to maximize the total and/or by tile parallelism and/or by performing programming operations, via such sequences of pulses, on direct cells and complementary cells at the same time, may be advantageous in order to speed up the program time of the PCM.

### Object and summary

An object of one or more embodiments is to contribute in providing such a solution.

According to one or more embodiments, that object is achieved via a method of operating phase change memories having the features set forth in the claims that follow.

One or more embodiments concern a corresponding memory device and a corresponding computer program product loadable in at least one processing circuit (for instance, a computer) and comprising software code portions for executing the steps of the method when the product is run on at least one processing circuit.

As used herein, reference to such a computer program product is understood as being equivalent to reference to a computer-readable medium containing instructions for controlling a processing system in order to co-ordinate implementation of the method according to one or more embodiments.

The claims are an integral part of the technical teaching provided in respect of the embodiments.

Solutions as described herein include a method of operating a Phase Change Memory, PCM device, the PCM device comprising a plurality of cells arranged in a plurality of tiles, such plurality of cells comprising a set of cells configured to be written via respective write operations,
the method comprising:
determining a first value, such first value indicating an upper number of cells included in a same tile of the plurality of tiles that are configured to be written in respective write operations at a common write time;
determining a second value, such second value indicating an upper number of cells included in the plurality of cells that are configured to be written in respective write operations at such common write time;
selecting, based on the first value, on the second value and on whether such write operations are set write operations or reset write operations, a plurality of subsets of such set of cells, each subset in the plurality of subsets comprising at least one cell candidate for being written in at least one of the respective write operations by applying a respective current pulse to such at least one cell;
wherein the method comprises, for each subset in the plurality of subsets:
   generating a respective current pulse; and
   applying at such common write time such respective current pulse to the at least one candidate cell in the subset.

Solutions as described herein facilitate reducing a time required for programming the PCM, for instance, by managing sequences of pulses in order to maximize the total and/or by tile parallelism and/or by performing programming operations, via such sequences of pulses, on direct cells and complementary cells at the same time, in order to speed up the program time of the PCM.

### Brief description of the figures

One or more embodiments will now be described, by way of example only, with reference to the annexed figures, wherein:
Figure 1 is a conventional structure of a PCM array;
Figure 2A and Figure 2B illustrate subsequent reset and set current pulses respectively;
Figure 3 is a structure configured to manage a plurality of current pulses to be used in program operations according to embodiments of the present description;
Figure 4 is an exemplary structure of a plurality of program divers, for instance, N+1 program drivers, used in program operations according to embodiments of the present description;
Figure 5 illustrates an exemplary content of a pulse parallelism register according to embodiments of the present description;
Figure 6 illustrates an exemplary content of a current pulse shape register according to embodiments of the present description; and
Figure 7 is an exemplary program sequence comprising a plurality of program operations, managed by the structure of Figure 3 according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

As described in the above, solutions as described herein aim at managing a plurality of program operations in a phase change memory at the same time, for instance, optimizing the performing of such program operations, in order to reduce a time required for programming the PCM.

Therefore, solutions as described herein can reduce the time required for programming the PCM, for instance, by managing sequences of pulses in order to maximize the total and/or by tile parallelism and/or by performing programming operations, via such sequences of pulses, on direct cells and complementary cells at the same time, in order to speed up the program time of the PCM.

Such managing of the plurality of program operations considers:
low beta values, for example around 0.45, of the transistors acting as selectors and coupled between the word lines WL and respective cells 100, such beta value being a parameter indicating a relationship between an output current, for instance, a collector current, and an input current, for instance, a base current, of such transistors acting as selectors;
IR drops, comprising word line IR drops and bit line IR drops, such IR drops being voltage drops caused by currents flowing through word line and bit line parasitic resistors, for instance, during a program operation performed on a cell; and
a maximum current that can be provided by a program pump, that is, a program pump drive capability, such program pump being configured to generate the current that is to be injected in the cells, for instance for performing the program operations.

In fact, if a program operation is performed on a cell that is to be programmed, such cell being coupled to a respective word line WL via a respective transistor acting as selector, the low beta value of the transistor may lead to most of the current injected in the cell that is to be programmed via such program operation flowing through the control terminal, for instance, the base terminal, of such transistor.

In addition, a (high) IR drop may limit the number of cells comprised in a same tile that can be programmed via program operations at the same time.

Such a limit resulting from the IR drop can arise for the behaviors described in the following.

In fact, it is noted that the IR drop affecting the word lines WL depends on a total current that is injected in such word lines WL during program pulses.

Such total current corresponds to the sum of the currents flowing in the cells programmed at the same time and connected to a same word line WL, inside a same tile.

If the IR drop affecting a word line WL increases, the voltage that is to be applied to the corresponding bit lines BL and the voltage provided as output by the program pump are to be increased in response.

It is further noted that, by construction, the current that a generic charge pump can provide decreases, thus, increasing the output voltage of the pump.

Therefore, the higher the number of cells in the same tile that are programmed at the same time:
the higher the IR drop on the corresponding word line WL;
the higher the voltage that is to be applied to the corresponding bit line BL;
the higher the voltage provided as output by the program pump; and
the lower the current that can be provided by the charge pump.

Furthermore, a total number of cells in the PCM, that is, in all the tiles, that can be programmed via program operations at the same time may be limited by such maximum current.

It is noted that, in the following, a two-cells-per-bit PCM architecture, that is, 2 cell/bit, is considered.

It is also noted that, even if the following description is mainly focused on PCM NVM structures, same conclusions also apply to computer storage technologies such as PCM, that is, Phase Change Memory, ePCM, that is, embedded Phase Change Memory, and/or ePCM NVM, that is, Non-Volatile Memory ePCM.

Solutions as described herein aims at, in PCM with 2 cells per bit architecture:
determining a maximum parallelism by tile, that is, a first limit value, that indicates the maximum number of cells 100 comprised in a same tile that can be written via respective program operations at a same time, such maximum parallelism by tile being limited by the IR drop inside the tile;
determining a total maximum parallelism, that is, a second limit value, that indicates the maximum number of cells 100 comprised in the array of the PCM that can be written via respective program operations at the same time, such total maximum parallelism being limited by the capability of a driver of the program pump, that is, by the maximum current that can be generated by such program pump;
determining one or more sets of cells that can be written at the same time (satisfying the previously described limits), such one or more sets of cells being determined in order to minimize a time requested for performing the program operations, considering that such program operations can be performed in parallel when respecting such limits, that is, such maximum parallelism by tile and such total maximum parallelism;
such operation of determining may be performed based on:
   typologies of the program operations that are to be performed, that is, set write operations and/or reset write operations,
   numbers related to the currently considered current pulses in a sequence of increasing current pulses, such sequence of increasing current pulses being a sequence of current pulses with increased values used in response to failed write operations in order to repeat the such write operations with current pulses with higher values,
   the determined maximum parallelism by tile, and
   the determined total maximum parallelism;
   generating a current pulse for each determined set of cells, obtaining a sequence of current pulses, that is, a sequence of set pulses and/or reset pulses; and
   providing, for each determined set of cells, the generated current pulse to each of the cells comprised in the considered set of cells in order to perform write operation on such cells at the same time, thus, performing program operations on a number of cells up to a maximum number of cells at the same time, such maximum number of cells being determined considering such maximum parallelism by tile and such total maximum parallelism.

To summarize, solutions as described herein comprise a method of operating a Phase Change Memory, PCM device, the PCM device comprising a plurality of cells 100 arranged in a plurality of tiles T, such plurality of cells 100 comprising a set of cells configured to be written via respective write operations.

The method comprises:
determining, for instance, by retrieving from a second set of registers 206 configured to store first values (that is, maximum parallelisms by tile) and second values (that is, total maximum parallelisms) and described in the following, a first value, that is, the maximum parallelism by tile, such first value indicating an upper number of cells included in a same tile of the plurality of tiles T that are configured to be written in respective write operations at a common write time t;
determining, for instance, by retrieving from the second set of registers 206, a second value, that is, the total maximum parallelism, such second value indicating an upper number of cells included in the plurality of cells 100 that are configured to be written in respective write operations at such common write time t;
selecting, for instance, using a second state machine 212 described in the following, based on the first value, on the second value and on whether such write operations are set write operations or reset write operations (that is, on the typologies of the program operations that are to be performed), a plurality of subsets of such set of cells, each subset in the plurality of subsets comprising at least one cell candidate for being written in at least one of the respective write operations by applying a respective current pulse, for instance, a current pulse with a value equal to a current control signal CURR GEN CTL, to such at least one cell;
wherein the method comprises, for each subset in the plurality of subsets:
   generating, for instance, using a first state machine 208 described in the following, a respective current pulse, for instance, the current pulse with the value equal to the current control signal CURR_GEN_CTL; and
   applying at such common write time t such respective current pulse CURR_GEN_CTL to the at least one candidate cell in the subset.

In addition, such method may select, for instance, via such second state machine 212, the plurality of subsets of such set of cells:
targeting a maximum value of the number of cells in each subset (that is, a maximum number of cells that can be pulsed at a same time) under the constraint that the number of cells candidate to be written, that is, to be pulsed, in respective write operations at such common write time included in a same tile of the plurality of tiles T does not exceed the first value (that is, the maximum number of cells in a same tile that can be pulsed at the same time without exceeding the constraint regarding the maximum parallelism by tile); and
the number of cells candidate to be written, that is, to be pulsed, in respective write operations at such common write time included in the plurality of cells 100 does not exceed the second value (that is, the maximum number of cells in a PCM array that can be pulsed at the same time without exceeding the constraint regarding the total maximum parallelism).

It is noted that such method may select, for instance, via such second state machine 212, the plurality of subsets of such set of cells by:
receiving, for instance, from a first data register 210ₐ, data to be programmed and, for instance, from a second data register 210_{b}, data currently stored/read in the PCM array; and
selecting the plurality of subsets of such set of cells, that is, determining which are the cells to be programmed (that is, the ones whose state is changed from SET to RESET and vice-versa), based on a difference between such data to be programmed and such data currently stored/read in the PCM array, for instance, by inhibiting programming operations on cells that already store correct data.

The method described herein may comprise determining the first value, that is, the maximum parallelism by tile, based on a voltage drop affecting such plurality of tiles T during such respective write operations, that is, limiting such maximum parallelism by tile using the IR drop inside each tile.

In addition, the PCM device may comprise a current pulse source, for instance, a "program" pump 216, of the PCM device to generate current pulses, the current pulse source 216 comprising a current pump.

The method described herein may comprise determining such second value, that is, the total maximum parallelism, based on a highest current value such current pump is configured to generate, that is, such total maximum parallelism can be limited by the capability of the driver of the program pump, that is, by the maximum current that can be generated by such program pump.

In fact, the program pump 216 may be configured to provide the current for programming a certain number of cells at the same time, such current that is provided (at a certain voltage) being limited, therefore, limiting the number of the cells that can be programmed in parallel.

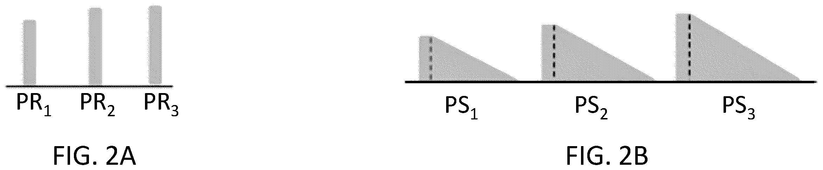

For instance, exemplary reset pulses and exemplary set pulses are illustrated in Figure 2A and Figure 2B respectively.

Figure 2A illustrates a sequence of increasing reset current pulses PR that can be used for reset write operations, including at least:
a first reset pulse PR1, for instance, with a rectangular shape, for instance, with a value that is about 240 µA and that lasts for about 0.1 µs, which is used in a first attempt of a reset write operation,
a second reset pulse PR2, for instance, with a rectangular shape, for instance, with a value that is about 270 µA and that lasts for about 0.1 µs, which is used in a second attempt of the reset write operation if the previous reset write operation failed, that is, if the first attempt of the reset write operation failed, and
a third reset pulse PR3, for instance, with a rectangular shape, for instance, with a value that is about 300 µA and that lasts for about 0.1 µs, which is used in a third attempt of the reset write operation if the previous reset write operation failed, that is, if the second attempt of the reset write operation failed.

It is noted that successive reset pulses have an increasing value, therefore, the value of the third reset pulse PR3 is higher than the values of the second reset pulse PR2 and the first reset pulse PR1, and the value of the second reset pulse PR2 is higher than the value of the first reset pulse PR1.

Figure 2B illustrates a sequence of increasing set current pulses PS that can be used for set write operations, including at least:
a first set pulse PS 1, for instance, comprising a first rectangular shape, for instance, with a maximum value that is about 160 µA which lasts for about 0.2 µs, and a second triangular shape, for instance, decreasing from the maximum value with a slope of about 0.045 µA/ns and that lasts for about 3.5 µs, as illustrated in Figure 2B, which is used in a first attempt of a set write operation,
a second set pulse PS2, for instance, comprising a first rectangular shape, for instance, with a maximum value that is about 230 µA which lasts for about 0.2 µs, and a second triangular shape, for instance, decreasing from the maximum value with a slope of about 0.045 µA/ns and that lasts for about 5 µs, as illustrated in Figure 2B, which is used in a second attempt of the set write operation if a previous set write operation failed, that is, if the first set write operation failed, and
a third set pulse PS3, for instance, comprising a first rectangular shape, for instance, with a maximum value that is about 260 µA which lasts for about 0.2 µs, and a second triangular shape, for instance, decreasing from the maximum value with a slope of about 0.045 µA/ns and that lasts for about 5.7 µs, as illustrated in Figure 2B, which is used in a third attempt of the set write operation if a previous set write operation failed, that is, if the second set write operation failed.

It is noted that successive set pulses have an increasing value, therefore, the value of the third set pulse PS3 is higher than the values of the second set pulse PS2 and the first set pulse PS 1, and the value of the second set pulse PS2 is higher than the value of the first set pulse PS1.

Therefore, write operations, for instance, either set write operations or reset write operations, performed after a previously failed write operations, for instance, either failed set write operations or failed reset write operations respectively, are performed with current pulses, for instance, set PS or reset PR current pulses respectively, of increased value in order to decrease the probability of a further failed write operation.

It is noted that the reset/set current pulses illustrated in Figures 2A and 2B are shown by way of example only, thus:
a smaller number of current pulses may be considered, for instance, a single or a pair of current pulses, or a higher number of current pulses, for instance, an additional current pulse may be used, for instance, to perform a fourth reset/set write operation if a previous reset/set write operation failed, that is, if the third reset/set write operation failed,
different current (µA) and time (µs) values may be considered for each of the reset/set current pulses, and/or
different shapes may be considered for each of the reset/set current pulses.

Therefore, the method disclosed herein may comprise, in response to the at least one candidate cell in the subset failing to be written as a result of such respective current pulse CURR GEN CTL being applied thereto, applying to such at least one candidate cell at least one further respective current pulse, for instance, the second reset pulse PR2, the third reset pulse PR3, the second set pulse PS2, or the third set pulse PS3, of higher intensity than such respective current pulse CURR_GEN_CTL, for instance, either the first reset pulse PR1 or the first set pulse PS 1.

In addition, such method may comprise applying to such at least one candidate cell such at least one further respective current pulse, for instance, PS2, PS3, PR2, or PR3, with a pulse waveform, for instance, from a first set of registers 204 described in the following comprising the shapes described in Figures 2A and 2B, different from the pulse waveform of such respective current pulse, for instance, PS1 or PR1.

The method described herein may comprise, in response to such at least one candidate cell having applied thereto such at least one further respective current pulse, for instance, PS2, PS3, PR2, or PR3, of higher intensity than such respective current pulse, for instance, PS1, or PR1, selecting again, for instance, via the second state machine 212, such plurality of subsets of such set of cells based on such first value, on such second value, on whether such write operations are set write operations or reset write operations (that is, on the typologies of such operations), and on such at least one candidate cell having applied thereto such at least one further respective current pulse of higher intensity than such respective current pulse (that is, on such numbers related to the currently considered current pulses in a sequence of increasing current pulses).

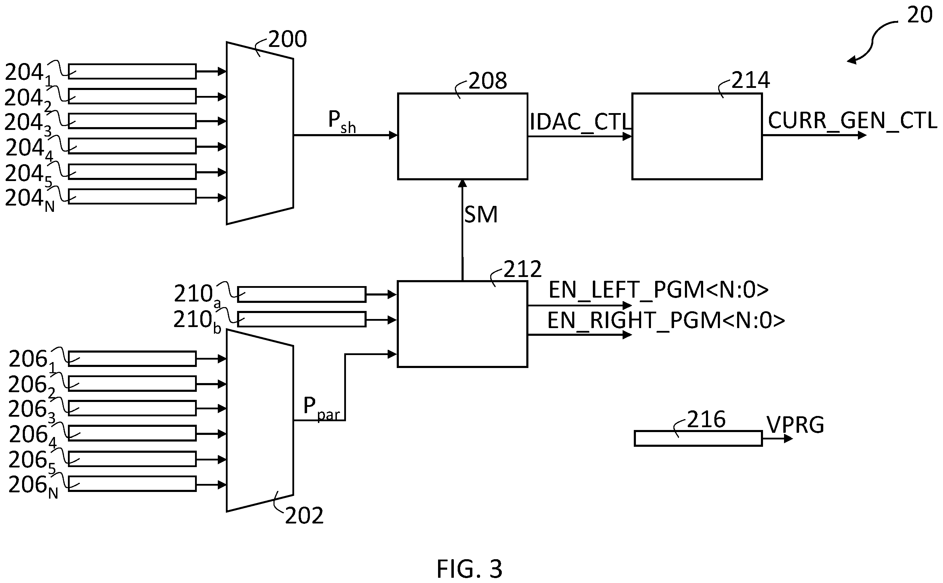

Figure 3 illustrates a structure 20 configured to manage a plurality of current pulses to be used in program operations.

Figure 3 illustrates a first 208 and a second 212 state machines, respectively used to manage:
a current pulse shape, for instance, depending on the type of pulse, that is, set or reset, and on the currently considered current pulse, that is, the number of the currently considered current pulse in the sequence of increasing current pulses, for instance, the first set/reset pulse PS1/PR1, the second set/reset pulse PS2/PR2, and the third set/reset pulse PS3/PR3; and
a pulse sequence, for instance, depending on a set of data to be programmed and, for each type of pulse, that is, set or reset, on the maximum parallelism by tile and on the total maximum parallelism.

Such first 208 and such second 212 state machines can be configured to retrieve input data from different types of registers with related selectors.

The first state machine 208, a pulse shape state machine, can be configured to retrieve input data from a first set of registers 204, comprising a plurality of registers 204₁, 204₂, 204₃, 204₄, 204₅, ..., and 204_{N}, referred to as current pulse shape registers.

Each current pulse shape register in such first plurality of registers 204 can be configured to store a respective set of pulse shape settings, such set of pulse shape settings allowing to determine a respective current pulse shape.

It is noted that such first plurality of registers 204 may be configured to comprise a register for each type of available current pulse.

For instance, considering the exemplary set pulses PS and the exemplary reset pulses PR described above, such first plurality of registers 204 may be configured to comprise six registers:
a first current pulse shape register 204, configured to store a first set of pulse shape settings, such first set of pulse shape settings allowing to determine the first set pulse PS1;
a second current pulse shape register 204₂ configured to store a second set of pulse shape settings, such second set of pulse shape settings allowing to determine the second set pulse PS2;
a third current pulse shape register 204; configured to store a third set of pulse shape settings, such third set of pulse shape settings allowing to determine the third set pulse PS3;
a fourth current pulse shape register 204₄ configured to store a fourth set of pulse shape settings, such fourth set of pulse shape settings allowing to determine the first reset pulse PR1;
a fifth current pulse shape register 204₅ configured to store a fifth set of pulse shape settings, such fifth set of pulse shape settings allowing to determine the second reset pulse PR2; and
a sixth current pulse shape register 204₆, for instance, referenced to as 204_{N} in Figure 3, configured to store a sixth set of pulse shape settings, such sixth set of pulse shape settings allowing to determine the third reset pulse PR3.

A current pulse shape register that is to be considered for a respective program operation, that is, a current pulse shape that is to be considered for performing such program operation, can be selected via a first selector block 200 out of such first plurality of registers 204.

Such first selector block 200, for instance, a multiplexer, may be configured to be coupled:
to each current pulse shape register in the first plurality of registers 204 via a respective first selector input terminal, and
to a state machine input terminal of the first state machine 208 via a first selector output terminal.

Such first selector block 200 may be further configured to:
receive, via such respective first selector input terminals, respective sets of pulse shape settings from each current pulse shape register in the first plurality of registers 204;
select one set of pulse shape settings out of the plurality of received sets of pulse shape settings, such operation of selecting being based on the type of pulse, that is, either set or reset, related to a program operation that is to be performed and on a currently considered current pulse, that is, the number of a currently considered current pulse in the sequence of increasing current pulses; and
provide, via such first selector output terminal, the selected set of pulse shape settings to the first state machine 208, for instance, using pulse shape setting bus Pₛₕ.

It is noted that such pulse shape setting data Pₛₕ may be retrieved using a bus storing data equal to the content of a selected register 204, that is, the register 204 storing the selected set of pulse shape settings.

Therefore, the content of a register in the first plurality of registers 204, that is, the register storing the selected set of pulse shape settings selected, for instance, via the first selector block 200, is sent to the first state machine 208.

The second state machine 212, a pulse sequencer state machine, may be configured to retrieve input data from a second set of registers 206, comprising a plurality of registers 206₁, 206₂, 206₃, 206₄, 206₅, ..., and 206_{N}, referred to as pulse parallelism registers.

Each pulse parallelism register in such second plurality of registers 206 may be configured to store a respective set of pulse parallelism settings, such set of pulse parallelism settings allowing to determine a respective maximum parallelism by tile and a respective total maximum parallelism.

It is noted that such second plurality of registers 206 may be configured to comprise a register for each type of available current pulse.

For instance, considering the exemplary set pulses PS and the exemplary reset pulses PR described above, such second plurality of registers 206 may be configured to comprise six registers:
a first pulse parallelism register 206₁ configured to store a first set of pulse parallelism settings, such first set of pulse parallelism settings allowing to determine a maximum parallelism by tile and a total maximum parallelism related to the first set pulse PS1;
a second pulse parallelism register 206₂ configured to store a second set of pulse parallelism settings, such second set of pulse parallelism settings allowing to determine a maximum parallelism by tile and a total maximum parallelism related to the second set pulse PS2;
a third pulse parallelism register 206s configured to store a third set of pulse parallelism settings, such third set of pulse parallelism settings allowing to determine a maximum parallelism by tile and a total maximum parallelism related to the third set pulse PS3;
a fourth pulse parallelism register 206₄ configured to store a fourth set of pulse parallelism settings, such fourth set of pulse parallelism settings allowing to determine a maximum parallelism by tile and a total maximum parallelism related to the first reset pulse PR1;
a fifth pulse parallelism register 206₅ configured to store a fifth set of pulse parallelism settings, such fifth set of pulse parallelism settings allowing to determine a maximum parallelism by tile and a total maximum parallelism related to the second reset pulse PR2; and
a sixth pulse parallelism register 206₆, for instance, referenced to as 206_{N} in Figure 3, configured to store a sixth set of pulse parallelism settings, such sixth set of pulse parallelism settings allowing to determine a maximum parallelism by tile and a total maximum parallelism related to the third reset pulse PR3.

A pulse parallelism register that is to be considered for a respective program operation, that is, a maximum parallelism by tile and a total maximum parallelism that are to be considered for performing such program operation, can be selected via a second selector block 202 out of such second plurality of registers 206.

Such second selector block 202, for instance, a multiplexer, may be configured to be coupled:
to each pulse parallelism register in the second plurality of registers 206 via a respective second selector input terminal, and
to a state machine input terminal of the second state machine 212 via a second selector output terminal.

Such second selector block 202 may be further configured to:
receive, via such respective second selector input terminals, respective sets of pulse parallelism settings from each pulse parallelism register in the second plurality of registers 206;
select one set of pulse parallelism settings out of the plurality of received sets of pulse parallelism settings, such operation of selecting being based on the type of pulse, that is, either set or reset, related to a program operation that is to be performed and on a currently considered current pulse, that is, the number of a currently considered current pulse in the sequence of increasing current pulses; and
provide, via such second selector output terminal, the selected set of pulse parallelism settings to the second state machine 212, for instance, using pulse parallelism setting bus Pₚₐᵣ.

It is noted that such pulse parallelism setting data Pₚₐᵣ may be retrieved using a bus storing data equal to the content of a selected register 206, that is, the register 206 storing the selected set of pulse parallelism settings.

Therefore, the content of a register in the second plurality of registers 206, that is, the register storing the selected set of pulse parallelism settings selected, for instance, via the second selector block 202, is sent to the second state machine 212.

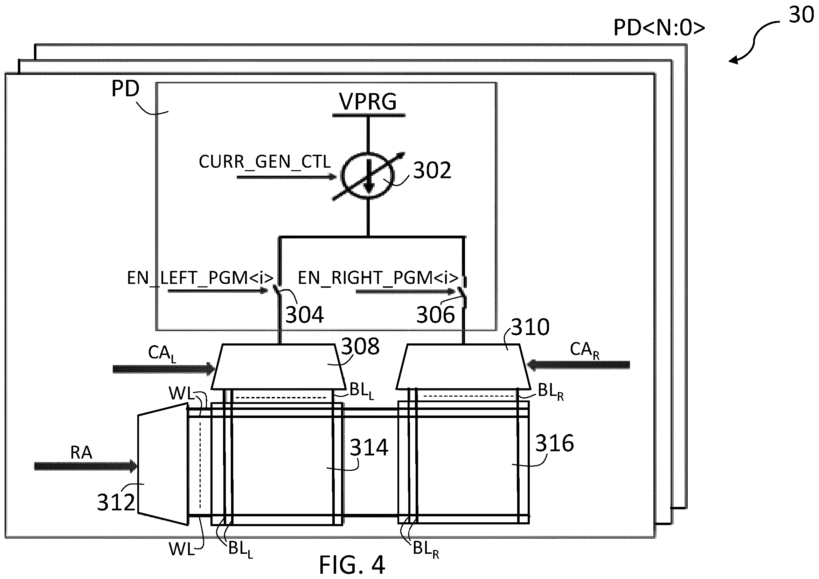

Therefore, the second state machine 212, that is, the pulse sequencer state machine, may be configured to:
receive, at one of its state machine input terminals, the selected set of pulse parallelism settings, for instance, via pulse parallelism setting bus Pₚₐᵣ sent by the second selector 202;
receive, for instance, from a first data register 210ₐ, at a second state machine input terminal, a first (binary) bus indicative of the data that are to be programmed via respective program operations and of corresponding cells where such data are to be written;
receive, for instance, from a second data register 210_{b}, at a third state machine input terminal, a second (binary) bus indicative of the data that are currently present in such corresponding cells where such data are to be written, for instance, read via respective read operations;
generate a first output bus EN_LEFT_PGM<N:0>, for instance, a first left output bus related to a first side of a sense amplifier, for instance, a left side, indicative of cells that are to be considered at the same time during the performing of program operations in a first subset of a PCM array, for instance, the subset 314 of Figure 4, based on such pulse parallelism setting bus Pₚₐᵣ, such first bus, and such second bus;
generate a second output bus EN_RIGHT_PGM<N:0>, for instance, a second right output bus related to a second side of the sense amplifier, for instance, a right side, indicative of cells that are to be considered at the same time during the performing of program operation in a second subset of the PCM array, for instance, the subset 316 of Figure 4, based on such pulse parallelism setting bus Pₚₐᵣ, such first bus, and such second bus; and
generate a second output signal SM, such second output signal SM being sent to the first state machine 208 and indicating to start the operations of the first state machine 208.

The operations of generating the first output bus EN_LEFT_PGM<N:0>, generating the second output bus EN_RIGHT_PGM<N:0>, and generating the second output signal SM performed by the second state machine 212 may be performed in response to such second state machine 212:
determining a difference between the data that are to be programmed via respective program operations related to corresponding cells where such data are to be written and the data that are currently present in such corresponding cells where such data are to be written (that is, the data already read and stored in a cell); and
selecting a pulse parallelism register in the second plurality of registers 206, that is, selecting a respective set of pulse parallelism settings allowing to determine a respective maximum parallelism by tile and a respective total maximum parallelism.

Such operation of determining the difference may be used to inhibit the performing of program operations on cells wherein the data that are to be written via such program operations and the data that are currently present in such cells are equal, thus, a program operation is not required.

The operation of selecting may be performed based on:
the type of pulse, that is, either set (if a cell to be written is in a reset state and is to be programmed in a set state) or reset (if a cell to be written in in a set state and is to be programmed in a reset state), related to a program operation that is to be performed, and
a currently considered current pulse, that is, the number of a currently considered current pulse in the sequence of increasing current pulses (that is, the number of attempts of the program operation that is to be performed).

To summarize, the method described herein may comprise:
receiving, at the second state machine 212, first binary logic levels, for instance, comprised a first data register 210ₐ, to be written in such plurality of cells 100 via respective write operations,
comparing, via such second state machine 212, such first binary logic levels with second, for instance, comprised in a second data register 210_{b}, already written in such plurality of cells 100; and
inhibiting, via such second state machine 212, respective write operations to cells in such plurality of cells 100 for which such first binary logic levels 210ₐ correspond with such second logic levels 210_{b}.

Thus, program operations may be performed just on cells wherein the data that are to be written via such program operations are different from the data that are currently present in such cells.

The first state machine 208, that is, the pulse shape state machine, may be configured to:
receive, at one of its state machine input terminals, the selected set of pulse shape settings, for instance, via pulse shape setting bus Pₛₕ sent by the first selector 200;
receive, at a second state machine input terminal, the second output signal SM sent by the second state machine 212; and
generate, in response to the reception of such second output signal SM, an IDAC ("Current Digital to Analog Converter") control bus IDAC_CTL based on received pulse shape setting bus Pₛₕ, thus, generating, based on the selected set of pulse shape settings, the current pulse shape that is to be applied to the cells during a considered program operation.

Such IDAC control bus IDAC_CTL can be a "digital" bus comprising information for describing current pulses that are to be applied to the cells during programming operations, for instance, binary data related to the amount of current of such current pulses.

The IDAC control bus IDAC_CTL may be received by an IDAC, that is, a Current Digital to Analog Converter, 214, such IDAC 214 being configured to generate a current control signal CURR_GEN_CTL based on the received IDAC control bus IDAC_CTL, converting the digital input bus, that is, the IDAC control bus IDAC_CTL, into such current pulses that are to be applied to the cells during programming operations, that is, the current control signal CURR_GEN_CTL.

Such IDAC 214 can be used in order to convert the digital output of the first state machine 208, that is, the IDAC control bus IDAC_CTL, in an analog current, that is, the current control signal CURR_GEN_CTL, related to the current that is to be injected into the cells.

Such current control signal CURR GEN CTL corresponds to the current pulse that is to be applied, via a respective program drivers PD, to the cells during programming operations.

Each program driver PD, for instance, each of the program drivers PD illustrated in Figure 4, is configured to copy such current control signal CURR_GEN_CTL and to inject the copied current control signal into respective cells that are to be programmed via programming operations.

Therefore, such current control signal CURR_GEN_CTL is used as a reference for each of such program drivers PD since each of such program drivers PD is configured to, during a pulse phase, copy such current control signal CURR GEN CTL in order to provide such copied current control signal CURR_GEN_CTL to such respective cells.

A "program" pump 216 can be configured to generate a given voltage VPRG used to generate a program current that is to be injected into the cells, therefore, such program pump 216 is configured to provide the current for performing programming operations on a certain number of cells at the same time.

As described before, it is noted that the current that the program pump 216 can provide (at a certain voltage) is limited, such limited current being a limit for the number of the cells that can be programmed in parallel.

Figure 4 is an exemplary structure of a plurality of program drivers PD, for instance, N+1 program drivers PD<N:0>, used in program operations and receiving the control buses generated by the first 208 and the second 212 state machines.

The array 10 of the PCM comprises a first subset of cells 314 and a second subset of cells 316, such first subset of cells 314 and such second subset of cells 316 being arranged in word lines WL and bit lines BL, for instance, the first subset of cells 314 is arranged in bit lines comprised in a first set of bit lines BL_{L} (that is, the bit lines comprised in the first set of bit lines BL_{L} are coupled to a first side - for instance, a left side - of a sense amplifier) and the second subset of cells 316 is arranged in bit lines comprised in a second set of bit lines BL_{R} (that is, the bit lines comprised in the second set of bit lines BL_{R} are coupled to a second side - for instance, a right side - of such sense amplifier).

To select a given cell 100, for instance, either in the first subset of cells 314 or in the second subset of cells 316, the word line WL and the bit line BL, that is, either a bit line BL_{L} of the first set or a bit lines BL_{R} of the second set respectively, coupled to the given cell 100 are to be selected.

The word lines WL can be selected, for instance, using a word line demultiplexer 312, based on a row address bus RA, indicative of the one or more cells in the first subset of cells 314 and/or in the second subset of cells 316 that are to be selected.

The bit lines BL_{L} of the first set can be selected, for instance, using a first bit line demultiplexer 308, based on a first column address bus CA_{L}, indicative of the one or more cells in the first subset of cells 314 that are to be selected.

The bit lines BL_{R} of the second set can be selected, for instance, using a second bit line demultiplexer 310, based on a second column address bus CA_{R}, indicative of the one or more cells in the second subset of cells 316 that are to be selected.

It is noted that, since if a direct cell is comprised in the first subset 314, the respective complementary cell is comprised in the second subset 316, and vice versa, such direct and complementary cells may share coordinate values, that is, the word line WL value and the bit line BL value.

For instance, if a direct cell (comprised, for instance, in the first subset 314) has as coordinates a given word line WL and a given bit line BL_{L} of the first set, the respective complementary cell (comprised, for instance, in the second subset 316) has as coordinates the same given word line WL and a given bit line BL_{R} of the second set, such given bit line BL_{R} of the second set having the same value of the given bit line BL_{L} of the first set.

Therefore, in such cases, the first column address bus CA_{L} and the second column address bus CA_{R} may be equal.

The selection of the bit lines BL_{L} of the first set and the selection of the bit lines BL_{R} of the second set can be performed based on the control buses generated via the first 208 and the second 212 state machines.

For instance, the first bit line demultiplexer 308 and the second bit line demultiplexer 310 can have their input terminals coupled to one or more program drivers PD, such program drivers PD being able to inject the generated program current on the cells comprised in the first subset 314 or in the second subset 316.

Such program drivers PD may be configured to:
receive the given voltage VPRG generated by the program pump 216;
receive the current control signal CURR_GEN_CTL generated by the IDAC 214, containing the information related to the current that is to be injected in the cells that are to be programmed via respective programming operations; and
receive the first output bus EN_LEFT_PGM<N:0> and the second output bus EN_RIGHT_PGM<N:0> generated by the second state machine 212, for instance, receiving an i-th component of such buses, that is, EN_LEFT_PGM<i> and EN_RIGHT_PGM<i>, indicative of cells that are to be considered at the same time during the performing of program operations in the first subset 314 and in the second subset 316 respectively via an i-th program driver PD<i>, where i is a number from 0 to N.

The program drivers PD may be configured to "copy", for instance, mirroring, the received current control signal CURR_GEN_CTL, for instance, via a current mirror 302, and to inject such copied current control signal into the cells that are to be programmed via respective programming operations.

For instance, such current mirror 302 can be supplied with the given voltage VPRG and, as previously described, configured to mirror such received current control signal CURR GEN CTL.

It is noted that each program driver in the program drivers PD may comprise a current mirror 302 for mirroring such received current control signal CURR_GEN_CTL in order to share a same current pulse shape for each cell that is to be programmed at the same time, even if such cells that are to be programmed at the same time are coupled to different program drivers PD.

Therefore, the current mirror 302 can be configured to generate the program current that is to be injected into the cells, such program current being supplied to the cells, for instance, via the first bit line demultiplexer 308 and the second bit line demultiplexer 310, through a pair of switches 304 and 306.

The first switch 304 of the pair of switches may be coupled between the current mirror 302 and the first bit line demultiplexer 308, such first switch 304 being configured to be controlled via the i-th component of the first output bus EN_LEFT_PGM<i>, that is, the first switch 304 may be configured to:
open, that is, being in a non-conductive state, in response to such i-th component of the first output bus EN_LEFT_PGM<i> indicating to not consider cells of the first subset 314 during the performing of program operations; and
close, that is, being in a conductive state, in response to such i-th component of the first output bus EN_LEFT_PGM<i> indicating to consider at least one cell of the first subset 314 at the same time during the performing of program operations.

The second switch 306 of the pair of switches may be coupled between the current mirror 302 and the second bit line demultiplexer 310, such second switch 306 being configured to be controlled via the i-th component of the second output bus EN_RIGHT_PGM<i>, that is, the second switch 306 may be configured to:
open, that is, being in a non-conductive state, in response to such i-th component of the second output bus EN_RIGHT_PGM<i> indicating to not consider cells of the second subset 316 during the performing of program operations; and
close, that is, being in a conductive state, in response to such i-th component of the second output bus EN_RIGHT_PGM<i> indicating to consider at least one cell of the second subset 316 at the same time during the performing of program operations.

Therefore, the operations of generating the first output bus EN_LEFT_PGM<N:0> and generating the second output bus EN_RIGHT_PGM<N:0> performed by the second state machine 212 may be considered in order to select, for instance, sequentially, and with a desired parallelism a group of N+1 program drivers PD coupled to the array of the PCM, such N+1 program drivers PD being configured to inject the program current into such array of the PCM.

In addition, such operations of generating the first output bus EN_LEFT _PGM<N:0> and the second output bus EN_RIGHT_PGM<N:0> performed by the second state machine 212 may be considered in order to determine, controlling the first switch 304 and the second switch 306, a side of the array of the PCM, that is, the first subset 314 or the second subset 316 respectively, wherein each of the N+1 program drivers PD has to inject the program current.

It is noted that each program driver in the N+1 program drivers PD can receive a couple of respective components of the first output bus EN_LEFT_PGM<N:0> and the second output bus EN_RIGHT_PGM<N:0>, for instance, an i-th program driver PDᵢ can be configured to receive the i-th component of the first output bus EN_LEFT_PGM<N:0> and the second output bus EN_RIGHT_PGM<N:0>, that is, EN_LEFT_PGM<i> and EN_RIGHT_PGM<i>.

It is noted that for each couple of components of the first output bus EN_LEFT_PGM<i> and the second output bus EN_RIGHT_PGM<i> related to the i-th program driver PDᵢ, only one of such components can indicate to activate the respective subset (either the first subset 314 or the second subset 316) via the respective switch (either the first switch 304 or the second switch 306, respectively).

In fact, the received current control signal CURR GEN CTL mirrored by the current mirror 302 can be received, for each of the program drivers PD, only by one of the two sides of the array, that is, either in the left side of the array (for instance, the first subset of cells 314) or in the right side of the array (for instance, the second subset of cells 316).

It is noted that is possible to have a component of the first output bus EN_LEFT_PGM<i> related to the i-th program driver PDᵢ and a component of the second output bus EN_LEFT_PGM<j> related to a j-th program driver PDⱼ (that is, components of the first output bus EN_LEFT_PGM<N:0> and the second output bus EN_RIGHT_PGM<N:0> comprised in different couples) both indicating to activate the respective subset (either the first subset 314 or the second subset 316) via the respective switch (either the first switch 304 or the second switch 306, respectively).

Therefore, in such a way, it is possible to perform programming operations at the same time on cells comprised in the first subset of cells 314, for instance, coupled to the left side of the sense amplifier, using some program drivers, and on other cells comprised in the second subset of cells 316, for instance, coupled to the right side of such sense amplifier, using other program drivers.

It is noted that each time a group of N+1 program drivers PD is selected, the second output signal SM, that is sent to the first state machine 208 in order to indicate to such state machine 208 to start its operations, can be generated by the second state machine 212.

Therefore, each time a group of N+1 program drivers PD is selected, the operation of generating, in response to the reception of such second output signal SM, the IDAC control bus IDAC_CTL can be performed by the first state machine 208, such operation of generating being configured to, based on the selected set of pulse shape settings, the current pulse shape, that is, the program current, that is to be applied to the at least one cell of the array of the PCM by such N+1 program drivers PD.

To summarize, the method described herein may comprise:
configuring a current pulse source, that is, the program pump 216 via a respective current mirror 302, of the PCM device to generate, via the first state machine 208, current pulses, for instance, the first set pulse PS1 or the first reset pulse PR1,
arranging such plurality of cells 100 in first cells, that is, the first subset of cells 314, and second cells, that is, the second subset of cells 316, generating, via the second state machine 212, a first switching bus, that is, the first output bus EN_LEFT_PGM<N:0>, in response to the at least one candidate cell in the subset being a first cell, that is, being comprised in the first subset 314, and generating a second switching bus, that is, the second output bus EN_RIGHT_PGM<N:0>, in response to the at least one candidate cell in the subset being a second cell, that is, being comprised in the second subset 316,
arranging pulse steering circuitry, that is, the circuitry comprising the first switch 304, the second switch 306, and, preferably, the first bit line demultiplexer 308 and the second bit line demultiplexer 310, between such current pulse source 216, 302 of the PCM device and such first cells, that is, the first subset 314, and second cells, that is, the second subset 316, the pulse steering circuitry configured to:
   receive the first switching bus EN_LEFT_PGM<N:0> and the second switching bus EN_RIGHT_PGM<N:0>, and
   direct current pulses generated by the PCM device, for instance, via the first state machine 208, towards such first cells, that is, the first subset 314, or towards such second cells, that is, the second subset 316, in response to such first switching bus EN_LEFT_PGM<N:0> or such second switching bus EN_RIGHT_PGM<N:0> being generated.

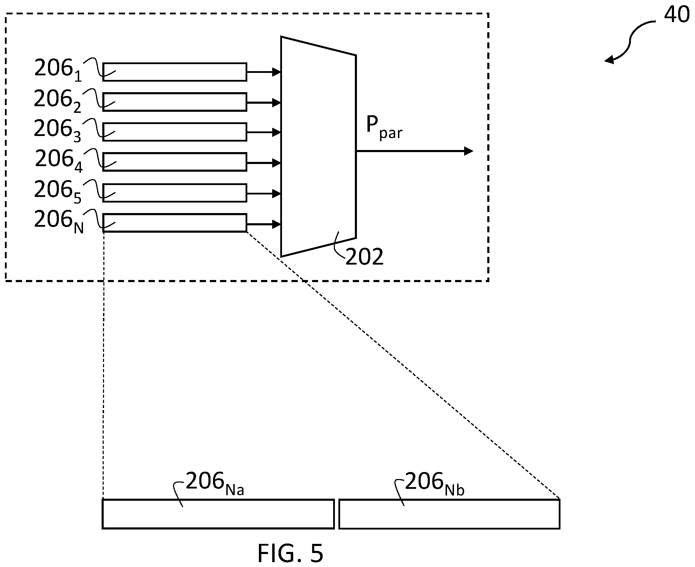

Figure 5 illustrates in a block diagram 40 an exemplary content 206_{Na}, 206_{Nb} of a pulse parallelism register 206, for instance, the pulse parallelism register 206_{N}, according to embodiments of the present description.

It is noted that even if the exemplary content 206_{Na}, 206_{Nb} is illustrated with reference to the pulse parallelism register 206_{N}, same conclusions also apply to the other registers in the second plurality of registers 206.

In fact, each pulse parallelism register in the second plurality of registers 206 may be divided in the following parts:
a first part 206_{Na}, comprising a value related to the maximum parallelism by tile, that is, a maximum number of cells that can receive the program current at the same time in a given tile; and
a second part 206_{Nb}, comprising a value related to the total maximum parallelism, that is, a maximum number of cells, considering all the tiles, that can receive the program current at the same time.

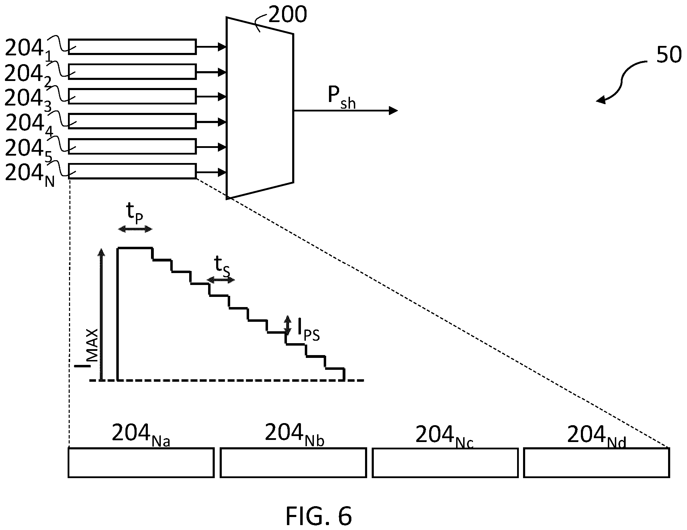

Figure 6 illustrates in a block diagram 50 an exemplary content 204_{Na}, 204_{Nb}, 204_{Nc}, and 204_{Nd} of a current pulse shape register 204, for instance, the current pulse shape register 204_{N}, according to embodiments of the present description.

Again, it is noted that even if the exemplary content 204_{Na}, 204_{Nb}, 204_{Nc}, and 204_{Nd} is illustrated with reference to the current pulse shape register 204_{N}, same conclusions also apply to the other registers in the first plurality of registers 204.

In fact, each current pulse shape register in the first plurality of registers 204 may be divided in, at least, the following parts:
a first register part 204_{Na}, storing a maximum current I_{MAX}, that is, the highest value reached by the current in the respective current pulse shape, either a set pulse or a reset pulse (it is noted that in Figure 6 a set pulse is considered, but same conclusions also apply to reset pulses);
a second register part 204_{Nb}, storing a plateau duration t_{P}, that is, the duration of the highest value reached by the current in the respective current pulse shape, either a set pulse or a reset pulse (it is noted that the plateau duration t_{P} of a reset pulse corresponds to the total duration of the reset pulse);
a third register part 204_{Nc}, storing a current pulse step I_{PS}, such current pulse step I_{PS} being used to define the current pulse shape and, in case of a set current pulse PS, the set current pulse slope. It is noted that if the current pulse is a reset current pulse PR, the current pulse step I_{PS} is equal to the maximum current I_{MAX};
a fourth register part 204_{Nd}, storing a step duration t_{S}, such step duration t_{S} being used to define the current pulse shape and, in case of a set current pulse PS, the set current pulse slope. It is noted that if the current pulse is a reset current pulse PR, the step duration t_{S} is equal to zero.

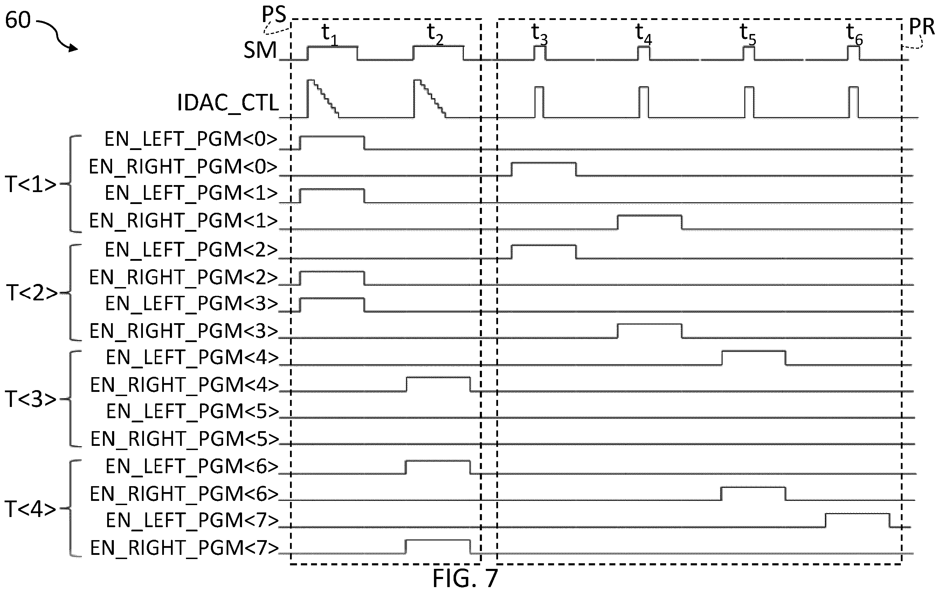

Figure 7 is an exemplary program sequence 60 comprising a plurality of program operations, managed by the structure of Figure 3 according to embodiments of the present description.

For the exemplary program sequence 60 of Figure 7, the following values are considered:
the presence of two program drivers PD per tile;
a maximum parallelism by tile related to set write operations, that is, to set current pulses, equal to two;
a total maximum parallelism related to set write operations, that is, to set current pulses, equal to four;
a maximum parallelism by tile related to reset write operations, that is, to reset current pulses, equal to one; and
a total maximum parallelism related to reset write operations, that is, to reset current pulses, equal to two.

It is noted that such numbers are reported herein by way of example only, so they are not intended to limit the scope of protection of the present application, in fact, any different number can be considered for the previously considered values without departing from the solution as disclosed herein.

For instance, Figure 7 considers a PCM comprising four tiles, that is, a first tile T<1>, a second tile T<2>, a third tile T<3>, and a fourth tile T<4>, each of such tile comprising two program drivers PD.

It is noted that the number of tiles and the number of program drivers for each tile is reported herein by way of example only, so it is not intended to limit the scope of protection of the present application, in fact, a different number of tiles and a different number of program drivers for each tile can be considered.

It is also noted that the logic levels and the program operations described in the following are reported herein by way of example only, so they are not intended to limit the scope of protection of the present application, in fact, different logic levels and different program operations can be considered.

For instance, in the example of Figure 7, the following cells are to be set, for instance, to high logic levels, via respective set write operations:
two cells comprised in the first subset 314 of the first tile T<1>;
a single cell comprised in the second subset 316 of the second tile T<2>;
a single cell comprised in the first subset 314 of the second tile T<2>;
a single cell comprised in the second subset 316 of the third tile T<3>;
a single cell comprised in the first subset 314 of the fourth tile T<4>; and
a single cell comprised in the second subset 316 of the fourth tile T<4>.

For instance, in the example of Figure 7, the following cells are to be set, for instance, to low logic levels, via respective reset write operations:
two cells comprised in the second subset 316 of the first tile T<1>;
a single cell comprised in the first subset 314 of the second tile T<2>;
a single cell comprised in the second subset 316 of the second tile T<2>;
a single cell comprised in the first subset 314 of the third tile T<3>;
a single cell comprised in the second subset 316 of the fourth tile T<4>; and
a single cell comprised in the first subset 314 of the fourth tile T<4>.

It is noted that a single program operation is performed in the third tile T<3>, therefore, a second program driver PD comprised in such third tile T<3> is configured to be off, for instance, to have both the switches 304 and 306 in a non-conductive state.

During a first time t₁, set write operations may be performed, in fact, in response to the reception of the second output signal SM, the first state machine 208 is configured to generate an IDAC control bus IDAC_CTL having the features, that is, the settings, of a set current pulse.

Therefore, since, as described above, the maximum parallelism by tile related to set write operations is two, a maximum of two set write operations may be performed at the same time within a same tile.

Hence, for example, the two previously described set write operations related to the first tile T< 1> may be performed during the first time t₁.

Since, as described above, the total maximum parallelism related to set write operations is four, a maximum of four set write operations may be performed at the same time within the PCM, for instance, within the four tiles previously described.

Hence, for example, also the two previously described set write operations related to the second tile T<2> may be performed during the first time t₁.

Similarly, during a second time t₂:
the previously described set write operation related to the third tile T<3> may be performed; and
the two previously described set write operations related to the fourth tile T<4> may be performed.

In this way, set write operations end after the first time t₁ and the second time t₂, that is, after a minimum time for performing such set write operations.

During a third time t₃, reset write operations may be performed, in fact, in response to the reception of the second output signal SM, the first state machine 208 is configured to generate an IDAC control bus IDAC_CTL having the features, that is, the settings, of a reset current pulse.

Therefore, since, as described above, the maximum parallelism by tile related to set write operations is one, just a single set write operation can be performed at the same time within a same tile.

Hence, for example, only one reset write operation of the two reset write operations that are to be performed on the two cells comprised in the second subset 316 of the first tile T<1> may be performed during such third time t₃, therefore, only one of the two cells is programmed during such third time t₃.

Since, as described above, the total maximum parallelism related to reset write operations is two, a maximum of two reset write operations may be performed at the same time within the PCM, for instance, within the four tiles previously described.

Hence, for example, also the reset write operation on the cell comprised in the first subset 314 of the second tile T<2> may be performed during such third time t₃, thus, performing a second reset write operation in a different tile.

Therefore, similarly:
the other of the two reset write operations to be performed on the two cells comprised in the second subset 316 of the first tile T<1> and the reset write operation on the cell comprised in the second subset 316 of the second tile T<2> may be performed during a fourth time t₄;
the reset write operation on the cell comprised in the first subset 314 of the third tile T<3> and the reset write operation on the cell comprised in the second subset 316 of the fourth tile T<4> may be performed during a fifth time t₅; and
the reset write operation on the cell comprised in the first subset 314 of the fourth tile T<4> may be performed during a sixth time t₆.

In this way, reset write operations end after the third time t₃, the fourth time t₄, the fifth time t₅, and the sixth time t₆, that is, even in this case, after a minimum time for performing such reset write operations.

Therefore, solutions as described herein facilitate achieving a method of operating a Phase Change Memory, PCM device, the PCM device comprising a plurality of cells arranged in a plurality of tiles, such plurality of cells comprising a set of cells configured to be written via respective write operations,
the method comprising:
determining a first value, such first value indicating an upper number of cells included in a same tile of the plurality of tiles that are configured to be written in respective write operations at a common write time;
determining a second value, such second value indicating an upper number of cells included in the plurality of cells that are configured to be written in respective write operations at such common write time;
selecting, based on the first value, on the second value and on whether such write operations are set write operations or reset write operations, a plurality of subsets of such set of cells, each subset in the plurality of subsets comprising at least one cell candidate for being written in at least one of the respective write operations by applying a respective current pulse to such at least one cell;
wherein the method comprises, for each subset in the plurality of subsets:
   generating a respective current pulse; and
   applying at such common write time such respective current pulse to the at least one candidate cell in the subset.

It is noted that solutions as described herein also applies to a Phase Change Memory, PCM device, the PCM device comprising a plurality of cells arranged in a plurality of tiles, such plurality of cells comprising a set of cells configured to be written via respective write operations; such PCM device being configured to implement the steps of the previously described method.

It is also noted that solutions as described herein also applies to a computer program product loadable in a control unit of a Phase Change Memory, PCM device, the PCM device comprising a plurality of cells arranged in a plurality of tiles, such plurality of cells comprising a set of cells configured to be written via respective write operations; the computer program product comprising portions of software code configured to cause the PCM device to implement the steps of the previously described method in response to the computer program product being run in the control unit of the PCM device.

Thus, solutions as described herein facilitate managing a plurality of program operations, that is, set write operations and reset write operations, in a phase change memory at the same time in order to reduce a time required for programming the PCM.

Solutions as described herein can reduce the time required for programming the PCM, for instance, by managing sequences of pulses in order to maximize the total and/or by tile parallelism and/or by performing programming operations, via such sequences of pulses, on direct cells and complementary cells at the same time, in order to speed up the program time of the PCM.

In fact, solutions as described herein facilitate obtaining a structure configured to optimize the program time of a PCM by performing writing operations in parallel first and second cells, using a maximum pulse parallelism limited by word lines IR drops and bit lines IR drops and, considering all the tiles, by the program pump drive capability.

Without prejudice to the underlying principles, the details and the embodiments may vary, even significantly, with respect to what has been described by way of example only without departing from the scope of the embodiments.

The extent of protection is determined by the annexed claims.

## Claims

1. A method of operating a Phase Change Memory, PCM device, the PCM device comprising a plurality of cells (100) arranged in a plurality of tiles (T), said plurality of cells (100) comprising a set of cells configured to be written via respective write operations,
the method comprising:
determining (206) a first value, said first value indicating an upper number of cells included in a same tile of the plurality of tiles (T) that are configured to be written in respective write operations at a common write time (t);
determining (206) a second value, said second value indicating an upper number of cells included in the plurality of cells (100) that are configured to be written in respective write operations at said common write time (t);
selecting (212), based on the first value, on the second value and on whether said write operations are set write operations or reset write operations, a plurality of subsets of said set of cells, each subset in the plurality of subsets comprising at least one cell candidate for being written in at least one of the respective write operations by applying a respective current pulse (CURR_GEN_CTL) to said at least one cell;
wherein the method comprises, for each subset in the plurality of subsets:
generating (208) a respective current pulse (CURR_GEN_CTL); and
applying (214; PD) at said common write time (t) said respective current pulse (IDAC_CTL; CURRENT_GEN_CTL) to the at least one candidate cell in the subset.

2. The method according to claim 1, comprising, in response to said at least one candidate cell in the subset failing to be written as a result of said respective current pulse (IDAC_CTL; CURRENT_GEN_CTL) being applied thereto, applying (214; PD) to said at least one candidate cell at least one further respective current pulse (PS2, PS3; PR2, PR3) of higher intensity than said respective current pulse (IDAC_CTL; CURRENT_GEN_CTL; PS1, PR1).

3. The method according to claim 2, comprising applying (214; PD) to said at least one candidate cell said at least one further respective current pulse (PS2, PS3; PR2, PR3) with a pulse waveform (204) different from the pulse waveform (204) of said respective current pulse (PS1, PR1).

4. The method according to claim 2 or claim 3, comprising, in response to said at least one candidate cell having applied thereto said at least one further respective current pulse (PS2, PS3; PR2, PR3) of higher intensity than said respective current pulse (PS1, PR1), selecting again (212) said plurality of subsets of said set of cells based on said first value, on said second value, on whether said write operations are set write operations or reset write operations, and on said at least one candidate cell having applied thereto said at least one further respective current pulse of higher intensity than said respective current pulse.

5. The method according to any of the previous claims, comprising selecting (212) the plurality of subsets of said set of cells targeting a maximum value of the number of cells in each subset under the constraint that the number of cells candidate to be written in respective write operations at said common write time included in a same tile of the plurality of tiles (T) does not exceed the first value (206) and the number of cells candidate to be written in respective write operations at said common write time included in the plurality of cells (100) does not exceed the second value (206).

6. The method according to any of the previous claims, comprising determining the first value (206) based on a voltage drop affecting said plurality of tiles (T) during said respective write operations.

7. The method according to any of the previous claims, comprising:
configuring a current pulse source (216, 302) of the PCM device to generate (208) current pulses (PS1, PR1),
arranging said plurality of cells (100) in first cells (314) and second cells (316), generating (212) a first switching bus (EN_LEFT_PGM<N:0>) in response to the at least one candidate cell in the subset being a first cell (314) and generating a second switching bus (EN_RIGHT_PGM<N:0>) in response to the at least one candidate cell in the subset being a second cell (316),
arranging pulse steering circuitry (308, 310; 304, 306) between said current pulse source (216, 302) of the PCM device and said first cells (314) and second cells (316), the pulse steering circuitry (308, 310; 304, 306) configured to:
receive the first switching bus (EN_LEFT_PGM<N:0>) and the second switching bus (EN_RIGHT_PGM<N:0>), and
direct current pulses generated by the PCM device (208) towards said first cells (314) or towards said second cells (316) in response to said first switching bus (EN_LEFT_PGM<N:0>) or said second switching bus (EN_RIGHT_PGM<N:0>) being generated.

8. The method according to any of the previous claims, wherein the PCM device comprises a current pulse source (216) of the PCM device to generate current pulses, the current pulse source (216) comprising a current pump, wherein said second value is determined (206) based on a highest current value said current pump is configured to generate.

9. The method according to any of the previous claims, comprising:
receiving (212) first binary logic levels (210ₐ) to be written in said plurality of cells (100) via respective write operations,
comparing (212) said first binary logic levels with second (210_{b}) already written in said plurality of cells (100); and
inhibiting (212) respective write operations to cells in said plurality of cells (100) for which said first binary logic levels (210ₐ) correspond with said second logic levels (210_{b}).

10. A Phase Change Memory, PCM device, the PCM device comprising a plurality of cells (100) arranged in a plurality of tiles (T), said plurality of cells (100) comprising a set of cells configured to be written via respective write operations;
said PCM device being configured to implement the method according to any of the previous claims.

11. A computer program product loadable in a control unit of a Phase Change Memory, PCM device, the PCM device comprising a plurality of cells (100) arranged in a plurality of tiles (T), said plurality of cells (100) comprising a set of cells configured to be written via respective write operations;
the computer program product comprising portions of software code configured to cause the PCM device to implement the method according to any of claims 1 to 9 in response to the computer program product being run in the control unit of the PCM device.
